# EUROPEAN PATENT APPLICATION

(11) **EP 4 797 887 A1**
(43) Date of publication of application: **26.08.2026**
(21) Application number: 24902136.1
(22) Date of filing: 05.08.2024
(51) Int. Cl.: H05K 5/02

(54) **PREPARATION METHOD FOR HOUSING, HOUSING AND ELECTRONIC APPARATUS**

(30) Priority: 14.12.2023 CN 202311719664
(71) Applicant: Honor Device Co., Ltd., Shenzhen, Guangdong 518040 (CN)
(72) Inventor: ZHANG, Shaohui, Shenzhen, Guangdong 518040 (CN)
(74) Representative: Isarpatent
(86) International application number: PCT/CN2024/109742
(87) International publication number: WO 2025/123710

(57) **Abstract**

This application provides a preparation method for a housing, a housing, and an electronic device. The preparation method for a housing includes: providing a metal cast, where the metal cast includes a metal matrix and a metal outer layer, the metal outer layer is located on an outer side of the metal matrix and is adjacent to the metal matrix, and a hole is formed in the metal outer layer; and performing thermal deformation and forging on a part of the metal outer layer that is away from the metal matrix to obtain a metal dense layer. A housing obtained by using the preparation method does not need a filler material, and surface consistency of the housing is good.

## Description

This application claims priority to Chinese Patent Application No. 202311719664.9, filed with the China National Intellectual Property Administration on December 14, 2023 and entitled "PREPARATION METHOD FOR HOUSING, HOUSING, AND ELECTRONIC DEVICE", which is incorporated herein by reference in its entirety.

### TECHNICAL FIELD

This application relates to the technical field of electronic devices, and in particular, to a preparation method for a housing, a housing, and an electronic device.

### BACKGROUND

Currently, in an electronic device on a market, a hole is usually formed in an outer surface of a housing of the electronic device due to a process problem, which causes a loose surface structure of the housing. In the conventional technology, the hole in the outer surface of the housing usually needs to be filled with a filler material by using a filling process, so that an appearance surface of the housing has a better appearance effect. However, because the housing and the filler material are different materials, adhesion of the filler material to the housing is prone to be poor, which causes relatively poor surface consistency of the housing.

### SUMMARY

An objective of embodiments of this application is to provide a preparation method for a housing, a housing, and an electronic device. A housing obtained by using the preparation method does not need a filler material, and surface consistency of the housing is good.

An embodiment of this application provides a preparation method for a housing, and the preparation method for a housing includes:
providing a metal cast, where the metal cast includes a metal matrix and a metal outer layer, the metal outer layer is located on an outer side of the metal matrix and is adjacent to the metal matrix, and a hole is formed in the metal outer layer; and
performing thermal deformation and forging on a part of the metal outer layer that is away from the metal matrix to obtain a metal dense layer.

In the preparation method for a housing provided in this embodiment of this application, by performing thermal deformation and forging on the part of the metal outer layer of the metal cast that is away from the metal matrix, thermal deformation is used to induce micro-flow of a material of the part of the metal outer layer of the metal cast that is away from the metal matrix. In other words, micro-flow of a part of the metal cast that is close to an outer surface occurs, which causes microstructural homogenization of the part of the metal outer layer that is away from the metal matrix after the flow, thereby forming the metal dense layer. In this case, in a thermal deformation and forging process, some holes in the metal outer layer and the outer surface of the metal cast are closed, so that a hole in an outer surface of the metal dense layer prepared is closed, and a porosity of the obtained metal dense layer is relatively low, thereby helping improve an appearance effect of the housing. In the preparation method for a housing provided in this embodiment of this application, the hole in the metal dense layer formed through thermal deformation and forging is closed, and a filling process is not required for the housing prepared, which helps improve the surface consistency of the housing. In addition, compared with the foregoing conventional process, a process of filling and grinding for a plurality of times is omitted, so that a manufacturing process is simple and costs are low. In addition, the metal dense layer is formed by performing thermal deformation and forging on the part of the metal outer layer that is away from the metal matrix, which helps improve structural strength of the housing.

In a possible implementation, a step of performing thermal deformation and forging on a part of the metal outer layer that is away from the metal matrix to obtain a metal dense layer includes:
performing thermal deformation and forging on the part of the metal outer layer that is away from the metal matrix to obtain a metal thermally deformed layer, where the metal thermally deformed layer includes the metal dense layer and a metal excess layer, and the metal excess layer is located on an outer side of the metal dense layer; and
removing the metal excess layer to obtain the housing. Removing the metal excess layer helps achieve an appearance effect that an outer surface of the housing does not have a hole, thereby helping improve the appearance effect of the housing.

In a possible implementation, a thickness of the metal excess layer is △H, and △H is 0.3 mm~0.5 mm.

In a possible implementation, the housing further includes an appearance layer, and the preparation method for a housing further includes: preparing the appearance layer on an outer surface of the dense layer. Compared with a manner in which the appearance layer is directly attached to the outer surface of the metal cast, a more stable gripping force can be formed between the metal dense layer and the appearance layer. In addition, the metal dense layer can show a better wear resistance capability and a better detachment resistance capability for the appearance layer, which improves a bonding capability between the metal dense layer and the appearance layer, thereby helping improve the appearance effect of the housing.

In a possible implementation, a temperature for thermal deformation and forging is 200°C~300°C.

An embodiment of this application further provides a housing, where the housing includes a metal matrix, a metal dense layer, and a metal adjacent layer, the metal dense layer is located on an outer side of the metal matrix and is spaced apart from the metal matrix, the metal adjacent layer is fixedly connected between the metal matrix and the metal dense layer, holes are formed in both the metal dense layer and the metal adjacent layer, and a porosity of the metal dense layer is less than a porosity of the metal adjacent layer.

In the housing provided in this embodiment of this application, the metal dense layer is disposed on the outer side of the metal matrix, and the porosity of the metal dense layer is less than the porosity of the metal adjacent layer, so that a surface structure of the metal dense layer is dense, and there is a relatively small hole or no hole in an outer surface of the metal dense layer. In this case, filling the metal dense layer with a filler material is not required, which avoids a problem that the hole in the outer surface of the housing needs to be filled additionally with the filler material, thereby avoiding a problem that the filler material is prone to fall off due to poor adhesion of the filler material to the housing. In addition, because the outer surface of the metal dense layer does not need to be filled with the filler material, outer surface consistency of the metal dense layer is good, which helps improve the appearance effect of the housing.

In a possible implementation, the porosity of the metal dense layer is ≤5%.

In a possible implementation, a hole diameter of the hole in the metal dense layer is ≤50 µm.

In a possible implementation, a thickness of the metal dense layer is D, and D is 0.3 mm~0.5 mm.

In a possible implementation, the housing further includes an appearance layer, and the appearance layer is disposed on the outer surface of the metal dense layer. The appearance layer is disposed to decorate the housing in terms of surface glossiness, color, and the like.

An embodiment of this application further provides an electronic device, including a functional module and the foregoing housing, where the functional module is mounted in the housing.

In a possible implementation, the housing is a middle bezel, the electronic device further includes a rear cover, and the rear cover is mounted in the middle bezel.

### BRIEF DESCRIPTION OF DRAWINGS

To describe the technical solutions in the embodiments of this application or in the prior art more clearly, the following briefly describes the accompanying drawings required for describing the embodiments or the prior art. Clearly, the accompanying drawings in the following description show some embodiments of this application, and persons of ordinary skill in the art may still derive other drawings from these accompanying drawings without creative efforts.
FIG. 1 is a schematic diagram of a top-view structure of an electronic device according to an embodiment of this application;
FIG. 2 is a schematic diagram of a cross section of a partial structure of a housing in the electronic device shown in FIG. 1;
FIG. 3 is a schematic diagram of a preparation procedure of the housing in the electronic device shown in FIG. 2;
FIG. 4 is a schematic diagram of a structure of a cross section of a casting mold that casts a metal cast in the preparation procedure shown in FIG. 3;
FIG. 5 is a schematic diagram of a structure of a cross section of a metal cast molded in the preparation procedure shown in FIG. 3;
FIG. 6 is a schematic diagram of a change in which an A part in the metal cast shown in FIG. 5 forms a metal substrate through thermal deformation and forging; and
FIG. 7 is a schematic diagram of a change in which a metal excess layer is removed from the metal cast after thermal deformation and forging shown in FIG. 6 and an appearance layer is prepared.

### DESCRIPTION OF EMBODIMENTS

The following clearly and completely describes the technical solutions in embodiments of this application with reference to the accompanying drawings in embodiments of this application. Clearly, the described embodiments are merely some rather than all of embodiments of this application. Based on embodiments of this application, all other embodiments obtained by a person of ordinary skill in the art without creative efforts fall within the protection scope of this application.

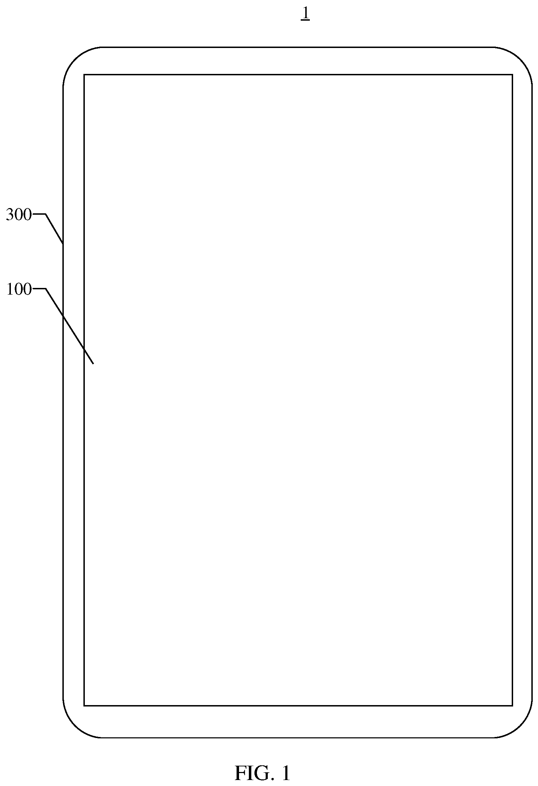

Referring to FIG. 1, FIG. 1 is a schematic diagram of a top-view structure of an electronic device 1 according to an embodiment of this application.

The electronic device 1 includes a functional module 100 and a housing 300, and the functional module 100 is mounted in the housing 300. The electronic device 1 may be a device such as a mobile phone, a tablet computer, a personal computer (Personal Computer, PC), or a wearable device. The wearable device includes a device such as a watch or a band. For example, the functional module 100 may be a display screen of the electronic device 1, and the housing 300 may be a middle bezel of the electronic device 1.

In this embodiment, an example in which the electronic device 1 is a mobile phone, the functional module 100 is a display screen of the mobile phone, and the housing 300 is a middle bezel of the mobile phone is used for description. The electronic device 1 further includes a rear cover, and the rear cover is mounted in the middle bezel.

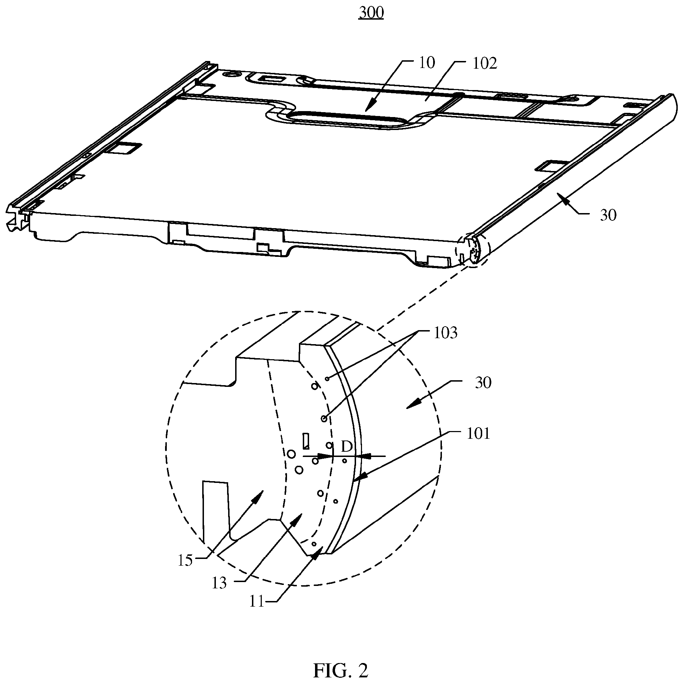

Referring to FIG. 2, FIG. 2 is a schematic diagram of a cross section of a partial structure of the housing 300 in the electronic device 1 shown in FIG. 1.

The housing 300 includes a metal substrate 10 and an appearance layer 30, and the appearance layer 30 is attached to an outer surface of the metal substrate 10. A "metal" in this embodiment of this application includes a pure metal and a metal alloy. For example, a material of the metal substrate 10 may be a magnesium alloy or an aluminum alloy.

Specifically, the outer surface of the metal substrate 10 includes an appearance surface 101 and a non-appearance surface 102. The non-appearance surface 102 is connected to the appearance surface 101. The appearance surface 101 of the metal substrate 10 is an outer surface of the metal substrate 10 that can be observed by a user in the assembled electronic device 1, and the non-appearance surface 102 is an outer surface of the metal substrate 10 that cannot be observed by the user in the assembled electronic device 1.

In a direction from the appearance surface 101 of the metal substrate 10 and away from an outer side of the metal substrate 10, the metal substrate 10 successively includes a metal dense layer 11, a metal adjacent layer 13, and a metal matrix 15. The metal adjacent layer 13 is connected between the metal dense layer 11 and the metal matrix 15, so that the metal adjacent layer 13 is adjacent to the metal dense layer 11 and is located on a side of the metal dense layer 11 that is away from the outer side of the metal substrate 10. Specifically, an outer surface of the metal dense layer 11 is the outer surface of the metal substrate 10, and the outer surface of the metal dense layer 11 includes the appearance surface 101. Holes 103 are formed in both the metal dense layer 11 and the metal adjacent layer 13. There is generally no hole 103 in the metal matrix 15. In this embodiment, a hole diameter of the hole 103 in the metal dense layer 11 is ≤50 µm.

In a direction from the appearance surface 101 of the metal substrate 10 and away from the outer side of the metal substrate 10, a thickness of the metal dense layer 11 is D. For example, D is 0.3 mm~0.5 mm. A measurement method for the thickness of the metal dense layer 11 is as follows: As shown in FIG. 2, a cross-sectional tangential section of the metal substrate 10 is made in a direction perpendicular to the appearance surface 101, a boundary is simulated in a region with the hole 103, and a boundary line is drawn between the metal dense layer 11 and the metal adjacent layer 13. A distance measured between the boundary line between the metal dense layer 11 and the metal adjacent layer 13 and a cross-sectional line of the appearance surface 101 is the thickness D of the metal dense layer 11.

In this embodiment, the metal dense layer 11, the metal adjacent layer 13, and the metal matrix 15 are of a same material. A porosity of the metal dense layer 11 is greater than a porosity of the metal matrix 15, and the porosity of the metal dense layer 11 is less than a porosity of the metal adjacent layer 13. In this embodiment, the porosity of the metal dense layer 11 is ≤5%. A calculation manner of "the porosity of the metal dense layer 11" is as follows: Based on the foregoing measurement method, a region of the metal dense layer 11 is formed between the boundary line drawn between the metal dense layer 11 and the metal adjacent layer 13 and the cross-sectional line of the appearance surface 101. In the region of the metal dense layer 11, a total area of the region of the metal dense layer 11 is S1, an area of a single hole 103 is S11, a quantity of holes 103 is N1, and the porosity of the metal dense layer 11=the area of the hole 103 in the region of the metal dense layer 11*the quantity of holes 103/the total area of the region of the metal dense layer 11=S11*N1/S1.

Similarly, a calculation manner of "the porosity of the metal adjacent layer 13" is as follows: Based on the foregoing measurement method, a boundary line is drawn between the metal adjacent layer 13 and the metal matrix 15, and a region of the metal adjacent layer 13 is formed between the boundary line between the metal dense layer 11 and the metal adjacent layer 13 and the boundary line between the metal adjacent layer 13 and the metal matrix 15. In the region of the metal adjacent layer 13, a total area of the region of the metal adjacent layer 13 is S2, an area of a single hole 103 is S22, a quantity of holes 103 is N2, and the porosity of the metal adjacent layer 13=the area of the hole 103 in the region of the metal adjacent layer 13*the quantity of holes 103/the total area of the region of the metal adjacent layer 13=S22*N2/S2.

The appearance layer 30 is attached to the outer surface of the metal dense layer 11, that is, is attached to a surface of the metal dense layer 11 that is away from the metal adjacent layer 13, so that the appearance layer 30 is attached to the appearance surface 101 of the metal substrate 10, and the appearance layer 30 is attached to the outer surface of the metal substrate 10. The appearance layer 30 may be configured to decorate the housing 300 in terms of surface glossiness, color, and the like. For example, the appearance layer 30 may be an organic resin appearance layer. In this embodiment, the appearance layer 30 may include a base coat layer, a middle coat layer, and a finish coat layer. The base coat layer is attached to the outer surface of the metal dense layer 11, the middle coat layer is attached to a surface of the base coat layer that is away from the metal dense layer 11, and the finish coat layer is attached to a surface of the middle coat layer that is away from the base coat layer.

In the housing 300 provided in this embodiment of this application, the metal dense layer 11 is disposed on an outer side of the metal matrix 15, and the porosity of the metal dense layer 11 is less than the porosity of the metal adjacent layer 13, so that a surface structure of the metal dense layer 11 is dense, and there is a relatively small hole or no hole in the outer surface of the metal dense layer 11. In this case, filling the metal dense layer 11 with a filler material is not required, which avoids a problem that the hole in the outer surface of the housing 300 needs to be filled additionally with the filler material, thereby avoiding a problem that the filler material is prone to fall off due to poor adhesion of the filler material to the housing 300. In addition, because the outer surface of the metal dense layer 11 does not need to be filled with the filler material, outer surface consistency of the metal dense layer 11 is good, which helps improve the appearance effect of the housing 300.

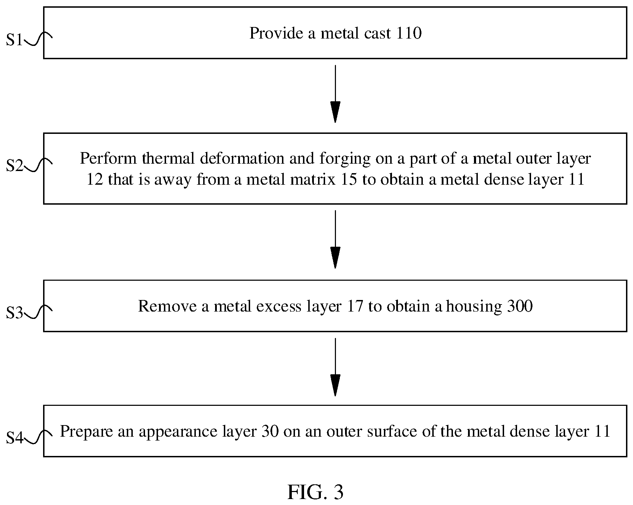

Referring to FIG. 3, FIG. 3 is a schematic diagram of a preparation procedure of the housing 300 in the electronic device 1 shown in FIG. 2.

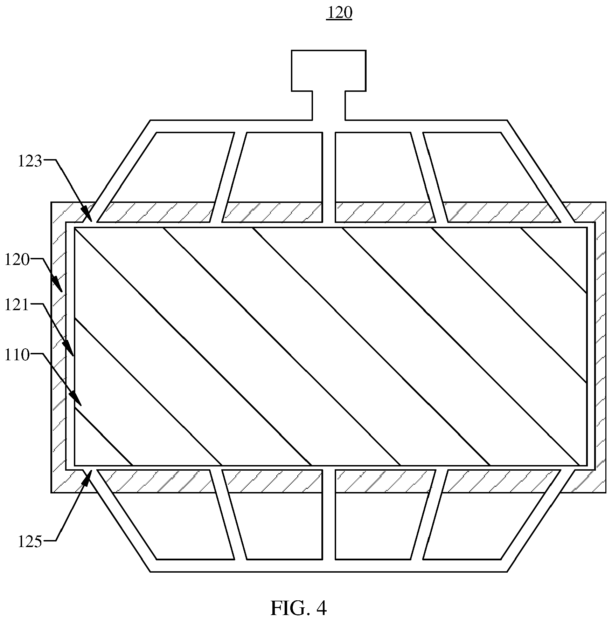

An embodiment of this application further provides a preparation method for the foregoing housing 300, including the following steps:
S1: Provide a metal cast 110. Specifically, referring to FIG. 4, FIG. 4 is a schematic diagram of a structure of a cross section of a casting mold 120 that casts a metal cast 110 in the preparation procedure shown in FIG. 3. The casting mold 120 is taken, and a cavity 121, a first opening 123, and a second opening 125 are disposed in the casting mold 120. The cavity 121 is disposed on an inner side of the casting mold 120, and both the first opening 123 and the second opening 125 communicate with the cavity 121. A molten metal raw material is poured into the cavity 121 from the first opening 123. An excess molten metal raw material may overflow from the second opening 125. The entire cavity 121 is filled with the molten metal raw material, which is cooled and molded into the metal cast 110 in the cavity 121.

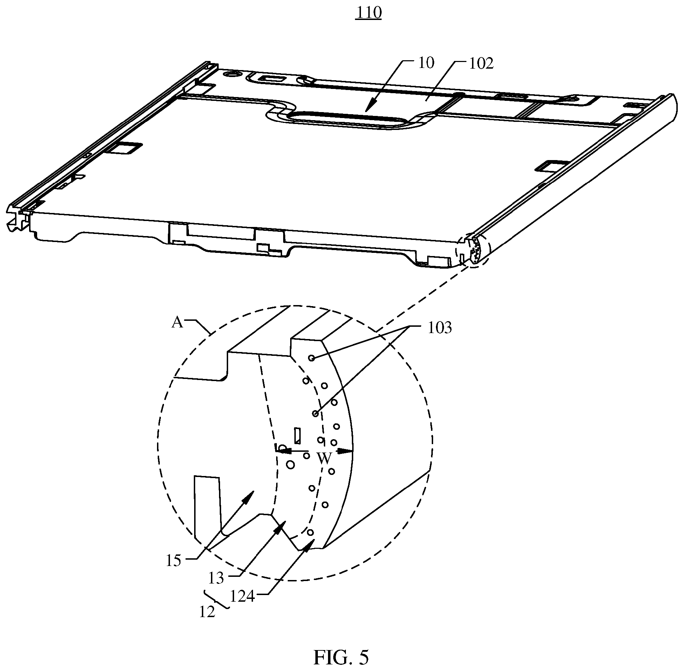

In a casting process of the metal cast 110, because the first opening 123 and the second opening 125 are in contact with an outer surface of the metal cast 110, gas easily enters a part (for example, a metal outer layer 12 in the metal cast 110 shown in FIG. 5) of the metal cast 110 that is close to an appearance surface from the first opening 123 and the second opening 125, so that holes 103 are prone to be formed in the part close to the appearance surface and in the appearance surface of the metal cast 110 obtained after molding (refer to FIG. 5). In addition, some materials contained in the metal raw material of the metal cast 110 can be gasified in a high-temperature state, so that the holes 103 are also formed in the part close to the appearance surface and in the appearance surface of the metal cast 110 (refer to FIG. 5).

With reference to FIG. 5, FIG. 5 is a schematic diagram of a structure of a cross section of a metal cast 110 molded in the preparation procedure shown in FIG. 3. In a direction from the outer surface of the metal cast 110 and away from an outer side of the metal cast 110, the metal cast 110 successively includes the metal outer layer 12 and a metal matrix 15 adjacent to the metal outer layer 12. The metal outer layer 12 faces the outer side of the metal cast 110, and a hole 103 is formed in the metal outer layer 12. For example, a thickness of the metal outer layer 12 is W. For measurement of the thickness W of the metal outer layer 12, refer to the foregoing measurement manner of the metal dense layer 11.

S2: Perform thermal deformation and forging on a part of a metal outer layer 12 that is away from a metal matrix 15 to obtain a metal dense layer 11. In this embodiment, a metal substrate 10 is obtained through thermal deformation and forging for the metal cast 110. Specifically, still referring to FIG. 5, in the direction from the outer surface of the metal cast 110 and away from the outer side of the metal cast 110, the metal outer layer 12 includes a surface layer 124 and a metal adjacent layer 13. The surface layer 124 faces the outer side of the metal cast 110, and the metal adjacent layer 13 is connected between the surface layer 124 and the metal matrix 15, so that the metal adjacent layer 13 is adjacent to the surface layer 124, and is located on a side of the surface layer 124 that is away from the outer surface of the metal cast 110. The surface layer 124 and the metal adjacent layer 13 are made of a same material, and a plurality of holes 103 are formed in both the surface layer 124 and the metal adjacent layer 13. Before thermal deformation and forging is performed on the metal outer layer 12 in the metal cast 110, a boundary between the surface layer 124 in the metal outer layer 12 and the metal adjacent layer 13 is not obvious, the plurality of holes 103 in the metal outer layer 12 are uneven in size and are irregularly distributed in regions of the surface layer 124 and the metal adjacent layer 13.

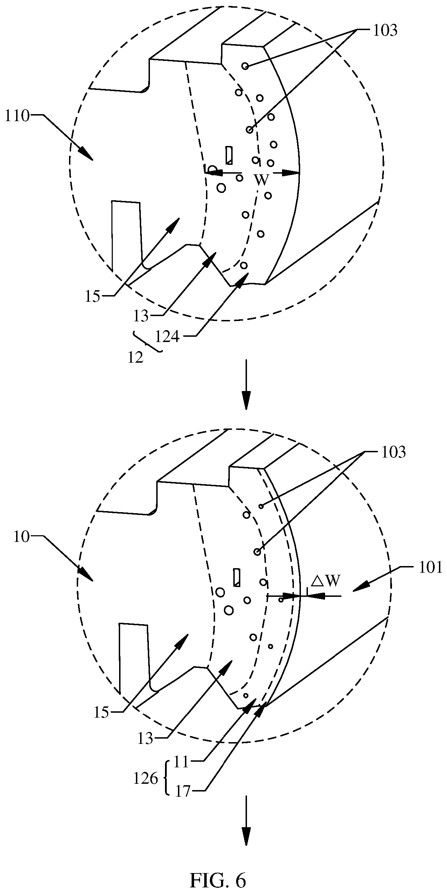

With reference to FIG. 6, FIG. 6 is a schematic diagram of a change in which an A part in the metal cast 110 shown in FIG. 5 forms a metal substrate 10 through thermal deformation and forging. Thermal deformation and forging is performed on the surface layer 124 in the metal outer layer 12, and the surface layer 124 is extruded to form the metal dense layer 11, to perform thermal deformation and forging on the metal cast 110 to prepare the metal substrate 10. Specifically, in a process of performing thermal deformation and forging on the metal cast 110, in a manner of thermal deformation on the surface layer 124, the surface layer 124 is extruded to form the metal dense layer 11. Micro-flow of a material of the surface layer 124 in the metal outer layer 12 occurs. After the flow, the holes 103 in the outer surface and the surface layer 124 of the metal cast 110 are closed, and the hole 103 in the metal adjacent layer 13 basically remains unchanged, so that the porosity of the metal dense layer 11 is less than the porosity of the metal adjacent layer 13. For example, a temperature for thermal deformation and forging is 200°C~300°C. After thermal deformation and forging is performed on the metal cast 110, a deformation amount of the metal dense layer 11 relative to the surface layer 124 in a thickness direction is △W, △W is 0.3 mm~0.5 mm, that is, a deformation amount △W of the metal substrate 10 relative to the metal cast 110 in a thickness direction of the surface layer 124 is 0.3 mm~0.5 mm. In this embodiment, the outer surface of the metal cast 110 includes a to-be-processed surface. In the thermal deformation and forging process, the metal cast 110 extrudes the to-be-processed surface, so that the surface layer 124 forms a metal thermally deformed layer 126 through thermal deformation and forging, and the to-be-processed surface of the metal cast 110 forms an appearance surface 101 of the metal substrate 10. For example, before thermal deformation and forging is performed on the metal cast 110, the thickness of the metal outer layer 12 may be 0.5 mm~1.0 mm, that is, a thickness of a part of the metal cast 110 close to the to-be-processed surface of the metal cast 110 is 0.5 mm~1.0 mm. The metal thermally deformed layer 126 includes the metal dense layer 11 and a metal excess layer 17, the metal dense layer 11 is connected between the metal adjacent layer 13 and the metal excess layer 17, and the metal excess layer 17 is located on an outer side of the metal dense layer 11.

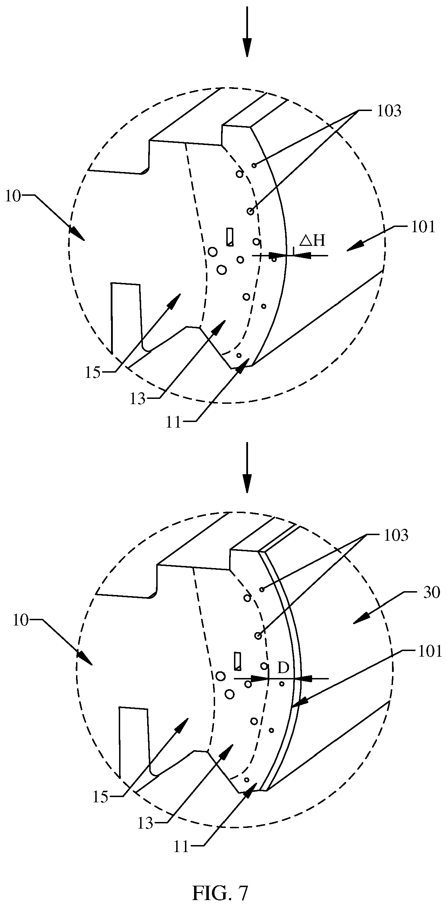

With reference to FIG. 7, FIG. 7 is a schematic diagram of a change in which the metal excess layer 17 is removed from the metal cast 110 after thermal deformation and forging shown in FIG. 6 and an appearance layer 30 is prepared.

S3: Remove a metal excess layer 17 to obtain a housing 300. In this embodiment, by using a manner of CNC (Computerized Numerical Control, computerized numerical control) processing, the metal excess layer 17 in the metal thermally deformed layer 126 is removed in a thickness direction of the metal thermally deformed layer 126. For example, a thickness of the metal excess layer 17 is △H, and △H is 0.3 mm~0.5 mm. After the metal excess layer 17 is removed, the thickness of the metal dense layer 11 is D. Removing the metal excess layer 17 helps implement an appearance effect that the outer surface of the metal substrate 10 does not have a hole 103, which improves an appearance effect of the metal substrate 10, thereby helping improve the appearance effect of the housing 300. It may be understood that the thickness of the metal excess layer 17 may be adjusted based on an actual requirement.

S4: Prepare an appearance layer 30 on an outer surface of the metal dense layer 11. For example, the appearance layer 30 may be prepared in a manner of spraying or physical vapor deposition (Physical Vapor Deposition, PVD). In this embodiment, a step of grinding the outer surface of the metal dense layer 11 is further included between step S4, to remove a tooling mark on the outer surface of the metal dense layer 11. In some embodiments, sandblasting and anodizing surface treatment may further be performed on the ground metal substrate 10, to improve adhesion of the appearance layer 30 to the outer surface of the metal dense layer 11 of the metal substrate 10, and in addition, to improve corrosion resistance and aesthetics of the metal substrate 10.

The housing 300 prepared in this embodiment of this application is taken to simulate a sample, and after simulating, the housing 300 meets a requirement for reliability such as bending resistance and drop resistance.

In the conventional technology, the metal cast 110 is prepared by mainly using the manner of CNC (Computerized Numerical Control, computerized numerical control) processing, processing time is long, and processing costs are high. In the preparation method for the housing 300 provided in this embodiment of this application, the metal cast 110 is provided through casting. Compared with a manner of preparing the metal casting 110 by using CNC processing, casting time is short, and costs are lower.

In addition, the hole 103 is formed in the outer surface of the metal cast 110 after casting, which affects the appearance effect of the metal cast 110, and further affects the appearance effect of the housing 300. In a conventional process, when the housing 300 is prepared by using the metal cast 110, CNC processing needs to be performed on the metal cast 110 first, and then the outer surface of the metal cast 110 is ground. Then, the hole 103 in the outer surface of the metal cast 110 is filled with a filler material by using a filling process, and the filler material is cured through baking. Afterwards, the outer surface of the metal cast 110 is ground again, and the steps of filling, baking, and grinding are repeated until the appearance effect of the metal cast 110 is qualified. Finally, the appearance layer 30 is coated on the outer surface of the metal cast 110 to form the housing 300. After the appearance layer 30 is removed from a surface of the housing 300 prepared in this manner, the metal cast 110 is exposed. A metallographic structure of the metal cast 110 is exposed by using an HF acid etching method. A filled location can be obviously observed on the surface of the metal cast 110, and there is a clear boundary between the filled location and a location that is not filled. The surface consistency of the housing 300 is poor, the appearance is uneven, a preparation procedure is long, and the appearance needs to be ground, filled, and baked for a plurality of times. A yield is low, and preparing costs are high.

In the preparation method for the housing 300 provided in this embodiment of this application, by performing thermal deformation and forging on the part of the metal outer layer 12 of the metal cast 110 that is away from the metal matrix 15, thermal deformation is used to induce micro-flow of a material of the part of the metal outer layer 12 of the metal cast 110 that is away from the metal matrix 15. In other words, micro-flow of a part of the metal cast 110 that is close to an outer surface occurs, which causes microstructural homogenization of the part of the metal outer layer 12 that is away from the metal matrix 15 after the flow, thereby forming the metal dense layer 11. In this case, in a thermal deformation and forging process, some holes 103 in the metal outer layer 12 and the outer surface of the metal cast 110 are closed, so that a hole 103 in an outer surface of the metal dense layer 11 prepared is closed, and a porosity of the obtained metal dense layer 11 is relatively low, thereby helping improve the appearance effect of the metal substrate 10 prepared, and further improving the appearance effect of the housing 300. In the preparation method for the housing 300 provided in this embodiment of this application, the hole 103 in the metal dense layer 11 formed through thermal deformation and forging is closed, and the filling process is not required for the housing 300 prepared, which improves surface consistency of the metal substrate 10, thereby helping improve the surface consistency of the housing 300. In addition, compared with the foregoing conventional process, a process of filling and grinding for a plurality of times is omitted, so that a manufacturing process is simple and costs are low. In addition, the metal dense layer 11 is formed by performing thermal deformation and forging on the part of the metal outer layer 12 that is away from the metal matrix 15, which further improves structural strength of the metal substrate 10, thereby helping improve structural strength of the housing 300.

In addition, compared with a manner in which the appearance layer 30 is directly attached to the outer surface of the metal cast 110, in this embodiment of this application, the part of the metal outer layer 12 that is in the metal outer layer 12 of the metal cast 110 and that is away from the metal matrix 15 is extruded to form the metal dense layer 11. A more stable gripping force can be formed between the metal dense layer 11 and the appearance layer 30. In addition, the metal dense layer 11 can show a better wear resistance capability and a better detachment resistance capability for the appearance layer 30, which improves a bonding capability between the metal substrate 10 and the appearance layer 30, thereby improving the appearance effect of the housing 300.

The foregoing descriptions are merely example embodiments of this application, and certainly are not intended to limit the protection scope of this application. A person of ordinary skill in the art may understand all or some procedures for implementing the foregoing embodiments, and equivalent variations made in accordance with the claims of this application shall fall within the scope of this application.

## Claims

1. A preparation method for a housing, wherein the preparation method for a housing comprises:
providing a metal cast, wherein the metal cast comprises a metal matrix and a metal outer layer, the metal outer layer is located on an outer side of the metal matrix and is adjacent to the metal matrix, and a hole is formed in the metal outer layer; and
performing thermal deformation and forging on a part of the metal outer layer that is away from the metal matrix to obtain a metal dense layer.

2. The preparation method for a housing according to claim 1, wherein a step of performing thermal deformation and forging on a part of the metal outer layer that is away from the metal matrix to obtain a metal dense layer comprises:
performing thermal deformation and forging on the part of the metal outer layer that is away from the metal matrix to obtain a metal thermally deformed layer, wherein the metal thermally deformed layer comprises the metal dense layer and a metal excess layer, and the metal excess layer is located on an outer side of the metal dense layer; and
removing the metal excess layer to obtain the housing.

3. The housing preparation method according to claim 2, wherein a thickness of the metal excess layer is △H, and △H is 0.3 mm~0.5 mm.

4. The preparation method for a housing according to any one of claims 1-3, wherein the housing further comprises an appearance layer, and the preparation method for a housing further comprises: preparing the appearance layer on an outer surface of the dense layer.

5. The preparation method for a housing according to any one of claims 1-3, wherein a temperature for thermal deformation and forging is 200°C~300°C.

6. A housing, wherein the housing comprises a metal matrix, a metal dense layer, and a metal adjacent layer, the metal dense layer is located on an outer side of the metal matrix and is spaced apart from the metal matrix, the metal adjacent layer is fixedly connected between the metal matrix and the metal dense layer, holes are formed in both the metal dense layer and the metal adjacent layer, and a porosity of the metal dense layer is less than a porosity of the metal adjacent layer.

7. The housing according to claim 6, wherein the porosity of the metal dense layer is ≤5%.

8. The housing according to claim 6, wherein a hole diameter of the hole in the metal dense layer is ≤50 µm.

9. The housing according to claim 6, wherein a thickness of the metal dense layer is D, and D is 0.3 mm~0.5 mm.

10. The housing according to any one of claims 6-9, wherein the housing further comprises an appearance layer, and the appearance layer is disposed on an outer surface of the metal dense layer.

11. An electronic device, comprising a functional module and the housing according to any one of claims 6-10, wherein the functional module is mounted in the housing.

12. The electronic device according to claim 11, wherein the housing is a middle bezel, the electronic device further comprises a rear cover, and the rear cover is mounted in the middle bezel.
